# EUROPEAN PATENT APPLICATION

(11) **EP 1 420 258 A1**
(43) Date of publication of application: **19.05.2004**
(21) Application number: 02760692.0
(22) Date of filing: 22.08.2002
(51) Int. Cl.: G01R 31/28

(54) **MEASUREMENT CONTROL APPARATUS**

(30) Priority: 23.08.2001 JP 2001253183
(71) Applicant: Advantest Corporation, Nerima-ku, Tokyo 179-0071 (JP)
(72) Inventor: SAKURAI, Ryuichi, ADVANTEST Corporation, Tokyo 179-0071 (JP); KASAHARA, Toshiharu, ADVANTEST Corporation, Tokyo 179-0071 (JP); SAITOH, Chiezoh, ADVANTEST Corporation, Tokyo 179-0071 (JP)
(74) Representative: Brunner, Michael John
(86) International application number: PCT/JP2002/008447
(87) International publication number: WO 2003/027693

(57) **Abstract**

Noise in measurement data received/transmitted from/to a measurement module is reduced. A measurement control unit (10) controls circuits (50a, 50b) to be measured and acquires measurement data from the circuits (50a, 50b) to be measured. Moreover, a CPU (20) controls the measurement control unit (10) via a bus (40). Since the CPU (20) does not directly control the cixcuits (50a, 50b) to be controlled, no data is passed between the CPU (20) and the measurement control unit (10). Accordingly, a control signal and the like transmitted by the bus (40) is not mixed in the measurement data and the control signal and the like transmitted from the CPU (20) does not become a noise, thereby reducing the noise in the measurement data.

## Description

### Technical Field

The present invention relates to reduction of a noise when data are passed between a control unit such as a CPU and a measurement module.

### Background Art

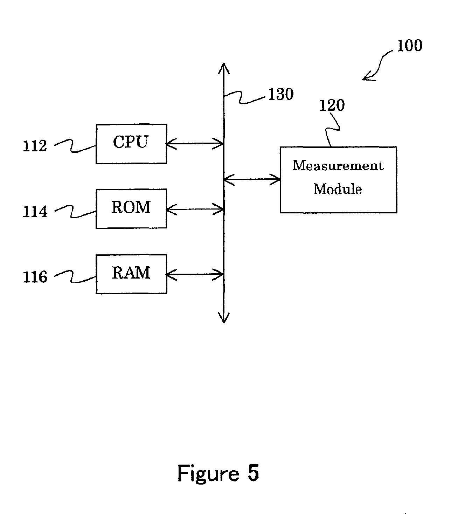

Fig. 5 shows a general constitution of a conventional measurement system. In the conventional measurement system 100, a CPU (Central Processing Unit) 112, a ROM (Read Only Memory) 114, a RAM (Random Access Memory) 116, and a measurement module 120 are connected to each other via a bus 130.

The CPU 112 reads a program and data from the ROM 114 and the RAM 116 via the bus 130, and according to them, transmits a synchronization clock signal and a control instruction to the measurement module 120. The measurement module 120 transmits measurement data representing a result of measurement to the CPU 112 via the bus 130. The CPU 112 writes the measurement data and the like to the RAM 116 via the bus 130.

In this way, not only the measurement data but also the synchronization clock signal, the control instruction, the program, and the data are passed to the individual units such as the CPU 112 via the bus 130.

However, the control instruction and the like passed to the individual units via the bus 130 act as a noise for the measurement data passed from the measurement module 120 and the like via the bus 130.

In view of the foregoing, an object of the present invention is to reduce the noise in the measurement data passed from the measurement module.

### Disclosure of Invention

According to the present invention as described in claim 1, a measurement control apparatus includes: a measurement control unit, connected to a subject to be measured, for controlling the subject to be measured, and for acquiring measurement data from the subject to be measured; a central control unit, connected to the measurement control unit, for controlling the measurement control unit; a control instruction memory for storing a control instruction used when the measurement control unit controls the subject to be measured; a bus for connecting the measurement control unit and the central control unit to each other; and a memory connected to the central control unit via the bus, wherein the measurement control unit includes: an individual control unit for controlling the subject to be measured; and an overall control unit for transmitting a synchronization clock signal to the individual control unit.

According to the measurement control apparatus constituted as described above, the measurement control unit connected to the subject to be measured controls the subject to be measured, and acquires the measurement data from the subject to be measured. Then, the central control unit connected to the measurement control unit controls the measurement control unit, and the control instruction memory stores the control instruction used when the measurement control unit controls the subject to be measured. In addition, the bus connects the measurement control unit and the central control unit to each other, and the central control unit and the memory are connected to each other via the bus.

According to the present invention as described in claim 2, the measurement control apparatus according to claim 1, further includes: a measurement data memory for receiving and storing the measurement data from the individual control unit.

The present invention as described in claim 3, is the measurement control apparatus according to claim 1, wherein the central control unit transmits a synchronization clock signal to the measurement control unit and the memory.

The present invention as described in claim 4, is the measurement control apparatus according to claim 1, wherein the overall control unit includes a first line for transmitting the synchronization clock signal to the individual control unit, and wherein the overall control unit includes a second line for acquiring the measurement data from the individual control unit.

### Brief Description of Drawings

Fig. 1 is a block diagram showing the constitution of a measurement control apparatus according to a first embodiment of the present invention.
Fig. 2 is a diagram showing the hardware constitution, wherein the measurement control unit 10 is constituted by software and hardware.
Fig. 3 is a block diagram showing the constitution of a measurement control apparatus according to a second embodiment of the present invention.
Fig. 4 is a block diagram showing the constitution of a measurement control apparatus according to a third embodiment of the present invention.
Fig. 5 shows a general constitution of a conventional measurement system.

### Best Mode for Carrying Out the Invention

Description will now be given of embodiments of the present invention with reference to drawings.

### First embodiment

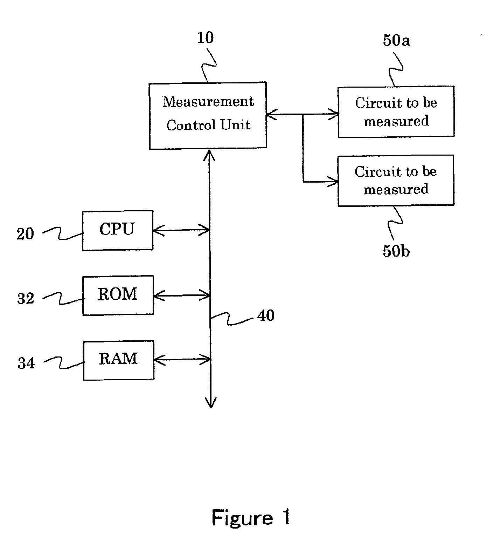

Fig. 1 is a block diagram showing the constitution of a measurement control apparatus according to a first embodiment of the present invention. The measurement control apparatus according to the first embodiment of the present invention is provided with: a measurement control unit 10, a CPU (central control means) 20, a ROM (Read Only Memory) 32, a RAM (Random Access Memory) 34, and a bus 40. The measurement control apparatus is connected to circuits 50a, b to be measured, and measures the circuits 50a, b to be measured.

The measurement control unit 10 is connected to the circuits 50a, b to be measured. In addition, the measurement control unit 10 controls the circuits 50a, b to be measured according to a control instruction. The measurement control unit 10 acquires measurement data from the circuits 50a, b to be measured. The control instruction used by the measurement control unit 10 is transmitted from the CPU (central control means) 20 before the start of the measurement.

The CPU (central control means) 20 is connected to the measurement control unit 10 via the bus 40. The CPU (central control means) 20 controls the measurement control unit 10. It should be noted that the CPU 20 connected to the memories such as the ROM 32 and the RAM 34 via the bus 40. The CPU 20 reads out a program and data from the ROM 32 and the RAM 34. Then, the CPU 20 writes the data to the RAM 34. The CPU 20 transmits a synchronization clock signal to the measurement control unit 10, the ROM 32, and the RAM 34 to synchronize them.

The ROM 32 and the RAM 34 are memories storing programs and data. The ROM 32 is a read-only memory, and the RAM 34 is a read/write memory.

The bus 40 connects the measurement control unit 10, the CPU 20, the ROM 32, and the RAM 34 to each other.

Description will now be given of the operation of the first embodiment.

First, the CPU 20 transmits the control instruction to the measurement control unit 10 before the start of the measurement. Then, the measurement starts. The measurement control unit 10 controls the circuits 50a, b to be measured according to the control instruction. The circuits 50a, b to be measured carry out predetermined operation, and output measurement data to the measurement control unit 10. The measurement data are passed between the measurement control unit 10 and the circuits 50a, b to be measured.

On the other hand, the CPU 20 controls the measurement control unit 10 via the bus 40. Further, the CPU 20 synchronizes the measurement control unit 10 and the ROM 32, the RAM 34 with each other via the bus 40. The CPU 20 reads the program and the data from the ROM 32 and the RAM 34, and writes them to the RAM 34 via the bus 40. A control signal and the like of the CPU 20 are passed via the bus 40.

According to the first embodiment, the measurement control unit 10 controls the circuits 50a, b to be measured, and the CPU 20 does not directly control the circuits 50a, b to be measured. Thus, the measurement data are not passed between the CPU 20 and the measurement control unit 10. Therefore, the measurement data are not transmitted over the bus 40, and the control signal and the like of the CPU 20 does not become a noise in the measurement data.

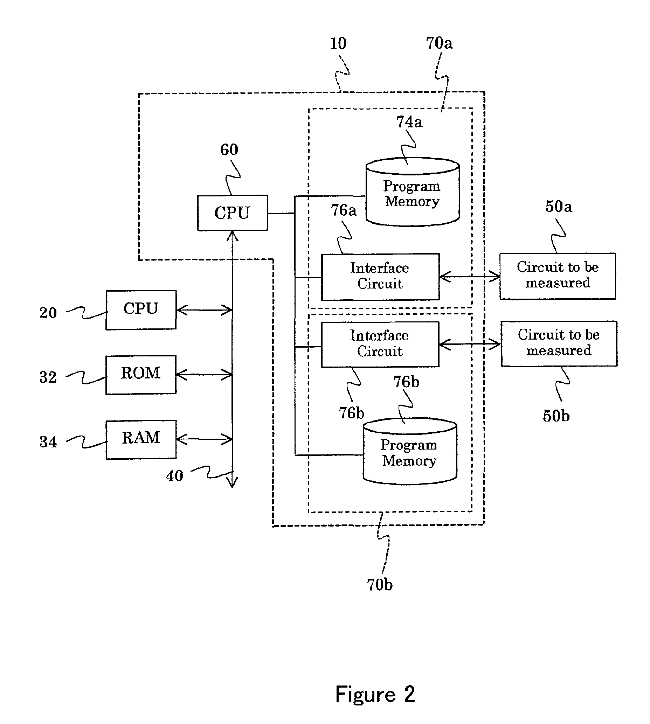

It should be noted that the measurement control unit 10 may be constituted by software and hardware, and the hardware constitution is shown in Fig. 2 for this case. The measurement control unit 10 is provided with a CPU 60, and modules 70a, b. The modules 70a, b are respectively provided with program memories 74a, b, and interface circuits 76a, b.

Programs (control instructions) for controlling the circuits 50a, b to be measured, and acquiring measurement data from the circuits 50a, b to be measured are stored respectively in the program memories 74a, b. The CPU 60 reads out the programs from the program memories 74a, b, controls the circuits 50a, b to be measured via the interface circuits 76a, b, and acquires the measurement data from the circuits 50a, b to be measured respectively. The interface circuits 76a, b serve as interfaces for respectively connecting the CPU 60 and the circuits 50a, b to be measured to each other. The CPU (central control means) 20 controls the CPU 60 connected to the bus 40. Since the CPU 60 applies measurement control processing to the circuits 50a, b to be measured, the CPU (central control means) 20 controls measurement control processing.

### Second embodiment

A second embodiment is different from the first embodiment in that the measurement control unit 10 is divided into a control sequencer 12 and target sequencers 14.

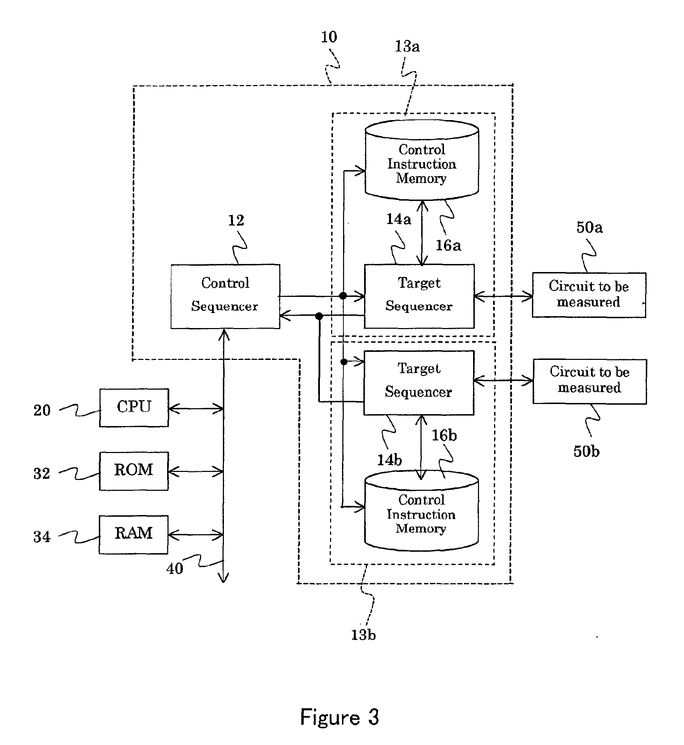

Fig. 3 is a block diagram showing the constitution of a measurement control apparatus according to a second embodiment of the present invention. The measurement control apparatus according to the first embodiment of the present invention is provided with: a measurement control unit 10, a CPU (central control means) 20, a ROM (Read Only Memory) 32, a RAM (Random Access Memory) 34, and a bus 40. Through the second embodiment, like components are denoted by like numerals as of the first embodiment, and will not be further explained.

The measurement control unit 10 includes the control sequencer (overall control means) 12, the target sequencers (individual control means) 14a, b, and control instruction memories 16a, b.

The control sequencer (overall control means) 12 is connected to the bus 40. The control sequencer 12 transmits a synchronization clock signal to the target sequencers (individual control means) 14a, b, and synchronizes the target sequencers 14a, b. The control sequencer 12 acquires measurement data from the target sequencers 14a, b.

The target sequencers 14a, b are respectively connected to the circuits 50a, b to be measured. The target sequencers 14a, b individually control the circuits 50a, b to be measured according to the control instructions. The target sequencers 14a, b acquire measurement data respectively from the circuits 50a, b to be measured.

The control instruction memories 16a, b record the control instructions which the target sequencers 14a, b use to control the circuits 50a, b to be measured respectively. The control instructions are transmitted from the control sequencer 12.

It should be noted that the target sequencer 14a and the control instruction memory 16a constitute a module 13a, and the target sequencer 14b and the control instruction memory 16b constitute a module 13b. The number of the modules may be two or more (three, four, ...).

The CPU 20, the ROM 32, the RAM 34, and the bus 40 are similar to those in the first embodiment.

Description will now be given of the operation of the second embodiment.

First, the CPU 20 transmits the control instructions to the measurement control unit 10 before the start of the measurement. The control instructions are stored in the control instruction memories 16a, b via the control sequencer 12.

Then, the measurement starts. The target sequencers 14a, b read out the control instructions from the control instruction memories 16 to respectively control the circuits 50a, b to be measured while they are being synchronized by the control sequencer 12. The circuits 50a, b to be measured carry out predetermined operation, and output measurement data to the target sequencers 14a, b. The target sequencers 14a, b output the measurement data to the control sequencer 12. Thus, the measurement data are passed between the measurement control unit 10 and the circuits 50a, b to be measured.

On the other hand, the CPU 20 controls the measurement control unit 10 via the bus 40. Further, the CPU 20 synchronizes the measurement control unit 10 and the ROM 32, the RAM 34 with each other via the bus 40. The CPU 20 reads the program and the data from the ROM 32 and the RAM 34, and writes them to the RAM 34 via the bus 40. The control signal and the like of the CPU 20 are passed via the bus 40.

The second embodiment provides the effects similar to those of the first embodiment.

### Third embodiment

A third embodiment is different from the second embodiment in that the measurement data are output to measurement data memories 18a, b.

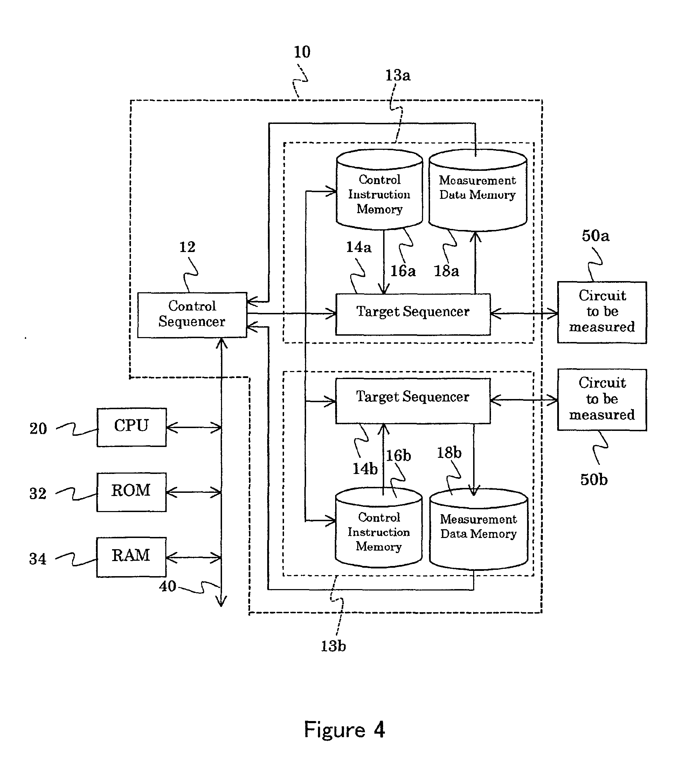

Fig. 4 is a block diagram showing the constitution of a measurement control apparatus according to a third embodiment of the present invention. The measurement control apparatus according to the third embodiment of the present invention is provided with: a measurement control unit 10, a CPU (central control means) 20, a ROM (Read Only Memory) 32, a RAM (Random Access Memory) 34, and a bus 40. Through the third embodiment, like components are denoted by like numerals as of the second embodiment, and will not be further explained.

The measurement control unit 10 includes the control sequencer 12, the target sequencers 14a, b, control instruction memories 16a, b, and measurement data memories 18a, b.

The control sequencer 12, the target sequencers 14a, b, and the control instruction memories 16a, b are identical to those of the second embodiment. The measurement data memories 18a, b are respectively connected to the target sequencers 14a, b, acquire the measurement data respectively from the target sequencers 14a, b, and record them. Note that the control sequencer 12 reads out the measurement data from the measurement data memories 18a, b.

The CPU 20, the ROM 32, the RAM 34, and the bus 40 are identical to those in the first embodiment.

It should be noted that the target sequencer 14a, the control instruction memory 16a, and the measurement data memory 18a constitute the module 13a, and the target sequencer 14b, the control instruction memory 16b, and the measurement data memory 18b constitutes the module 13b. The number of the modules may be two or more (three, four, ...).

Description will now be given of the operation of the third embodiment.

First, the CPU 20 transmits the control instructions to the measurement control unit 10 before the start of the measurement. The control instructions are stored in the control instruction memories 16a, b via the control sequencer 12.

Then, the measurement starts. The target sequencers 14a, b read out the control instructions from the control instruction memories 16 to respectively control the circuits 50a, b to be measured while they are being synchronized by the control sequencer 12. The circuits 50a, b to be measured carry out predetermined operation, and output measurement data to the target sequencers 14a, b. The target sequencers 14a, b output the measurement data to the measurement data memories 18a, b. Thus, the measurement data are passed between the measurement control unit 10 and the circuits 50a, b to be measured. The measurement data stored in the measurement data memories 18a, b are read out by the control sequencer 12.

On the other hand, the CPU 20 controls the measurement control unit 10 via the bus 40. Further, the CPU 20 synchronizes the measurement control unit 10 and the ROM 32, the RAM 34 with each other via the bus 40. The CPU 20 reads the program and the data from the ROM 32 and the RAM 34, and writes them to the RAM 34 via the bus 40. The control signal and the like of the CPU 20 are passed via the bus 40.

The third embodiment provides the effects similar to those of the first embodiment.

According to the present invention, the measurement control means is connected to the subject to be measured, and acquires the measurement data from the subject to be measured. Thus, the measurement data are passed between the measurement control means and the subject to be measured.

On the other hand, the central control means is connected to the measurement control means, and controls the measurement control means. Thus, the control signal and the like of the central control means are passed between the central control means and the measurement control means. The measurement control means controls the subject to be measured, and the central control means does not directly control the subject to be measured. Thus, the measurement data are not passed between the central control means and the measurement control means.

Therefore, the control signal and the like of the central control means do not become the noise in the measurement data.

## Claims

1. A measurement control apparatus comprising:
a measurement control means, connected to a subject to be measured, for controlling said subject to be measured, and for acquiring measurement data from said subject to be measured;
a central control means, connected to said measurement control means, for controlling said measurement control means;
a control instruction memory for storing a control instruction used when said measurement control means controls said subject to be measured;
a bus for connecting said measurement control means and said central control means to each other; and
a memory connected to said central control means via said bus,
wherein said measurement control means comprises: an individual control means for controlling said subject to be measured; and an overall control means for transmitting a synchronization clock signal to said individual control means.

2. The measurement control apparatus according to claim 1, further comprising:
a measurement data memory for receiving and storing said measurement data from said individual control means.

3. The measurement control apparatus according to claim 1,
wherein said central control means transmits a synchronization clock signal to said measurement control means and said memory.

4. The measurement control apparatus according to claim 1,
wherein said overall control means comprises a first line for transmitting said synchronization clock signal to said individual control means, and
wherein said overall control means comprises a second line for acquiring said measurement data from said individual control means.
